Europäisches Patentamt

European Patent Office

Office européen des brevets

(19)

(11) Veröffentlichungsnummer: **0 334 983**

**A1**

(12) # EUROPÄISCHE PATENTANMELDUNG

(21) Anmeldenummer: **88105243.5**

(22) Anmeldetag: **31.03.88**

(51) Int. Cl.⁴: **H03K 19/003 , H03K 5/13 , H03K 3/354**

(43) Veröffentlichungstag der Anmeldung:
**04.10.89 Patentblatt 89/40**

(84) Benannte Vertragsstaaten:
**DE FR GB IT NL**

(71) Anmelder: **Deutsche ITT Industries GmbH
Hans-Bunte-Strasse 19 Postfach 840
D-7800 Freiburg(DE)**

(72) Erfinder: **Gahle, Hans-Jürgen, Dr.
Panoramastrasse 13
D-7830 Emmendingen(DE)**
Erfinder: **Uhlenhoff, Arnold, Dipl.-Ing.
Hölderlinstrasse 33
D-7830 Emmendingen(DE)**

(54) **Integrierte CMOS/NMOS-Schaltung.**

(57) Diese hat Teilfunktionen, die jeweils für sich mittels eines einzigen Grundschaltungstyps, wie z.B Addier- (sm), Multiplizier- (m), Dividier- (d), Komparator- (k), Speicher-, (sp), Schieberegister- (sr), Analog/Digital-Wandler- (ad), Digital/Analog-Wandler-(da) oder Abtast-Halte-Zellen (ah), Flipflops (f), Inverter (ic, id) oder Gatter (g) derart aufgebaut sind, daß eine Teilanzahl p von für die jeweilige Teilfunktion benötigten Grundschaltungen als CMOS-Grundschaltungen (C) und deren restliche Teilanzahl (q) als Enhancement-NMOS-Grundschaltungen (N) mit einer Stromquelle, insbesondere mit einem Depletion-Transistor (d1), als Lastelement realisiert sind und die Teilanzahl p so gewählt ist, daß die Betriebsspannungsabhängigkeit der Signallaufzeit der CMOS-Grundschaltungen (C) durch die Betriebsspannungsabhängigkeit der Signallaufzeit der NMOS-Grundschaltungen (N) kompensiert ist. Ein entsprechender Ringoszillator enthält p hintereinandergeschaltete CMOS-Inverter (ic) und q auf diese folgende, hintereinandergeschaltete NMOS-Depletion-Load-Inverter (id).

FIG. 1

FIG. 2

EP 0 334 983 A1

## Integrierte CMOS/NMOS-Schaltung

Die Erfindung betrifft integrierte CMOS/NMOS-Schaltungen, wie sie in der Zeitschrift "Microelectronics Journal", 1982, Seiten 29 bis 32, insbesondere Seite 32, beschrieben sind. Danach hängt die Wahl, ob eine spezielle digitale Teilfunktion in CMOS- oder in NMOS-Technik realisiert wird, von den Erfordernissen bezüglich der Arbeitsgeschwindigkeit und der Packungsdichte der integrierten Schaltung ab. Es wird also vorausgesetzt, daß die Kombination der CMOS-und der NMOS-Technik auf dem jeweiligen Chip dieser digitalen integrierten Schaltung in der Weise vorgenommen wird, daß spezielle Teilfunktionen entweder nur in CMOS- oder nur in NMOS-Technik realisiert werden.

Im Hinblick auf die erwähnte Schaltgeschwindigkeit der integrierten Schaltung liegt der Erfindung das Problem zugrunde, daß die die Schaltgeschwindigkeit bzw. Grenzfrequenz bestimmende Signallaufzeit eines einfachen CMOS-Elements, insbesondere des CMOS-Inverters, betriebsspannungsabhängig ist, wie für den CMOS-Inverter aus der Zeitschrift "NEREM Record", 1967, Seiten 168 und 169, hervorgeht. Diese Spannungsabhängigkeit wirkt sich z.B. dann sehr störend aus, wenn die in CMOS-Technik realisierte Teilfunktion im wesentlichen die erwähnte Signallaufzeit ausnützt, wie dies z.B. für Verzögerer, insbesondere in digitalen Filtern, oder auch für die unten noch näher erläuterten Ringoszillatoren zutrifft.

Die Aufgabe der in den Ansprüchen gekennzeichneten Erfindung besteht daher darin, diese Spannungabhängigkeit der Signallaufzeit von in CMOS-Technik realisierten Teilfunktionen der integrierten CMOS/NMOS-Schaltung zu kompensieren. Mit Teilfunktion ist damit eine solche Untereinheit der integrierten Schaltung bezeichnet, die für sich mittels eines einzigen, insbesondere digitalen, Grundschaltungstyps realisiert ist. Solche digitalen Grundschaltungstypen sind z.B. Addier-, Multiplizier-, Dividier-, Komparator-, Speicher-, Schieberegister-, Analog-Digital-Wandler-, Digital/Analog-Wandler- oder Abtast-Halte-Zellen, aber auch Flipflops, Inverter oder Gatter etc. Addierer, Multiplizierer etc. sind also aus Zellen aufgebaut gedacht.

Mit Gatter ist dabei jede beliebige logische Schaltung bezeichnet, an deren einzigem Ausgang ein der logischen Verknüpfung der Eingangssignale entsprechendes Signal auftritt. Das einfachste Gatter ist der Inverter.

Der Grundgedanke, auf der die Erfindung zur Lösung der Aufgabe beruht, besteht darin, innerhalb einer Teilfunktion CMOS/NMOS-Schaltung eine Teilanzahl p der dafür benötigten Grundschaltungen als CMOS-Grundschaltungen und deren restliche Teilanzahl q als Enhancement-NMOS-Grundschaltungen mit einer Stromquelle, insbesondere mit einem Depletion-Transistor, als Lastelement, bevorzugt also als sogenannte Depletion-Load-NMOS-Grundschaltungen, zu realisieren und damit von der vorbeschriebenen und eingangs erläuterten Realisierungsart abzugehen, bei der nur ganze Teilfunktionen in jeweils einer der genannten Techniken realisiert werden.

Durch die erfindungsgemäße Lösung gelingt es, z.B. die Schwingfrequenz der erwähnten Ringoszillatoren ohne zusätzliche Spannungsregelschaltung betriebsspannungsunabhängig zu machen. Somit bedarf es zur erfindungsgemäßen Lösung keiner zusätzlichen Fläche des Chips, die bei einer Spannungsregelschaltung ja erforderlich wäre.

Die Erfindung wird nun anhand der Figuren der Zeichnung näher erläutert.

Fig. 1 zeigt stark schematisiert den beliebigen Aufbau einer integrierten Schaltung nach der Erfindung, und

Fig. 2 zeigt das ebenfalls stark schematisierte Schaltbild eines Ringoszillators nach der Erfindung.

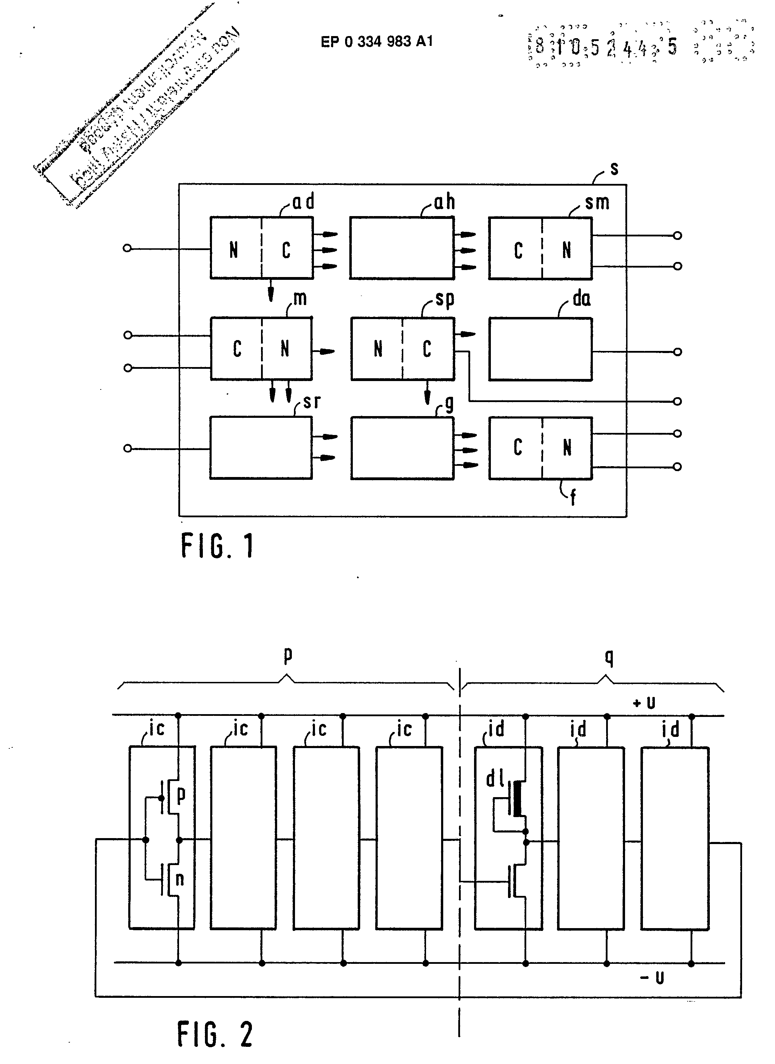

In Fig. 1 ist stark schematisiert und, ohne aufgrund der vielen Variationsmöglichkeiten von integrierten Schaltungen eine Beschränkung vorzunehmen, der mögliche Aufbau der integrierten Schaltung s dargestellt, die auf einem einzigen Chip realisiert ist. Aus den vielen möglichen Grundschaltungstypen zur Realisierung einzelner in sich abgeschlossener Teilfunktionen sind in Fig. 1 der Analog/Digital-Wandler ad, die Abtasthalteschaltung ah, der Addierer sm, der Multiplizierer m, der Speicher sp, der Digital/Analog- Wandler da, das Schieberegister sr, das Gatter g und die Flipflops f gezeigt. Die integrierte Schaltung s kann auch Analogstufen, wie z.B. Verstärker etc. enthalten.

Durch die auf der linken Seite der integrierten Schaltung s liegenden äußeren Anschlüsse sollen Eingangsleitungen und durch die auf der rechten Seite liegenden äußeren Anschlüsse Ausgangsleitungen veranschaulicht sein. Innerhalb der integrierten Schaltung s haben die durch die erwähnten Grundschaltungstypen realisierten Teilfunktionen durch Pfeile gekennzeichnete Ausgangsleitungen, die entweder innerhalb der integrierten Schaltung s zu anderen Teilfunktionen oder auch zu weiteren Ausgangsleitungen führen. Auch können die einzelnen Teilfunktionen weitere Eingangsleitungen haben, die von anderen Teilfunktionen der integrierten Schaltung c zu ihnen hinführen. Die konkrete Ausgestaltung der Verknüpfung der einzelnen Teilfunktionen ist vom speziellen Aufbau und der Gesamtfunktion der integrierten Schaltung s abhängig, für die sie konzipiert ist. Für die Erfindung spielt diese spezielle Innenverdrahtung keine Rolle , d.h. die Erfindung ist bei allen integrierten Schaltungen anwendbar.

Im Ausführungsbeispiel der Fig. 1 sind nun einige der erwähnten Teilfunktionen entsprechend der Erfindung realisiert, d.h. die Teilanzahl p der für die Realisierung dieser Teilfunktionen erforderlichen Grundschaltungstypen ist in CMOS-Technik und die restliche Teilanzahl q in Enhancement-NMOS-Technik, also mit den entsprechenden jeweiligen Grundschaltungen C, N, realisiert. In Fig. 1 sind dies rein beispielsweise der Analog-Digital-Wandler ad, der Addierer sm, der Multiplizierer m, der Speicher sp und die Flipflops f.

Die Gesamtzahl p + q der für eine Teilfunktion erforderlichen Grundschaltungstypen ist entsprechend der Erfindung so in die Teilanzahlen p, q aufgeteilt, daß die Betriebsspannungsabhängigkeit der Signallaufzeit der CMOS-Grundschaltungen C durch die Betriebsspannungsabhängigkeit der Signallaufzeit der NMOS-Grundschaltungen N kompensiert ist.

Die Fig. 2 zeigt die Anwendung des der Erfindung zugrundeliegenden Prinzips bei einem Ringoszillator, wie er in digitalen integrierten Schaltungen häufig, z.B. zur Erzeugung· von Taktsignalen oder zur Messung der Gatterlaufzeit, verwendet wird. Ein Ringoszillator ist bekanntlich die zur Schwingungsanfachung phasenrichtige Hintereinanderschaltung von Invertern, bei denen der Ausgang des letzten mit dem Eingang des ersten verbunden ist, so daß sie den "Ring" bilden. Zur Erfüllung der erwähnten Schwingungsbedingung sind im allgemeinen eine ungerade Anzahl von Invertern zu einem Ring zusammengeschaltet. Wenn die Schwingung unterbrechbar sein soll, wird einer der Inverter z.B. als NOR- oder NAND-Gatter realisiert, über das mittels eines Signals die "richtige" Phasenbedingung aufgehoben werden kann.

Fig. 2 zeigt einen Ringoszillator mit sieben zum Ring geschalteten Invertern. Entsprechend der Erfindung ist nun die Teilanzahl p mittels der CMOS-Inverter ic und die Teilanzahl q mittels der Depletion-Load-Inverter id realisiert. Im Ausführungsbeispiel der Fig. 2 bilden vier CMOS-Inverter ic und drei Depletion-Load-Inverter id den Ringoszillator, wobei der Depletion-Transistor dl als entsprechendes Lastelement geschaltet ist.

Mittels der jeweiligen Layout-Parameter und der Herstellungsparameter läßt sich die Betriebsspannungsunabhängigkeit sehr genau einstellen. Beim Ausführungsbeispiel der Fig. 2 mit p = 4 und q = 3 hatten der P- und der N-Transistor der CMOS-Inverter ic jeweils eine Kanallänge von 1,5 Mikrometern, der P-Transistor jeweils eine Kanalweite von 30 Mikrometern und eine Gate-Schwellspannung von -0,75 V und der N-Transistor jeweils eine solche von 15 Mikrometern bzw. + 0,75 V.

Die Depletion-Load-Inverter id der Fig. 2 waren in zwei "Gruppen" aufteilt; bei zwei Depletion-Load-Inverter hatten die Depletion-Transistoren jeweils eine Kanallänge von 2 Mikrometern und jeweils eine Kanalweite von 14 Mikrometern und die Enhancement-Transistoren jeweils eine Kanallänge von 1,5 Mikrometern und jeweils eine Kanalweite von 15 Mikrometern. Beim dritten Depletion-Load-Inverter hatte der Depletion-Transistor eine Kanallänge von 2 Mikrometern und eine Kanalweite von 20 Mikrometern und der Enhancement-Transistor eine Kanallänge von 1,5 Mikrometern und eine Kanalweite von 15 Mikrometern. Alle Depletion-Transistoren hatten eine Gate-Source-Schwellspannung von -2 V und alle Enhancement-Transistoren wiederum eine Gate-Schwellspannung von + 0,75 V.

Für andere Zahlenwerte von p, q kann der Fachmann entsprechende Dimensionierungen aufgrund der ihm zur Verfügung stehenden Layout-Rules und Herstellungsvcrschriften leicht durch Versuche ermitteln.

## Ansprüche

1. Integrierte CMOS/NMOS-Schaltung (s) mit, insbesondere digitalen, Teilfunktionen, die jeweils für sich mittels eines einzigen Grundschaltungstyps, wie z. B. Addier- (sm), Multiplizier- (m), Dividier- (d), Komparator- (K), Speicher- (sp), Schieberegister- (sr), Analog/Digital-Wandler- (ad), Digital/Analog-Wandler-(da) oder Abtast-Halte-Zellen (ah), Flipflops (f), Inverter (ic, id) oder Gatter (g) derart aufgebaut sind, daß eine Teilanzahl p von für die jeweilige Teilfunktion benötigten Grundschaltungen als CMOS-Grundschaltungen (C) und deren restliche Teilanzahl (q) als Enhancement-NMOS-Grundschaltungen (N) mit einer Stromquelle, insbesondere mit einem Depletion-Transistor (ld), als Lastelement realisiert sind und die Teilanzahl p so gewählt ist, daß die Betriebsspannungsabhängigkeit der Signallaufzeit der CMOS-Grundschaltungen (C) durch die Betriebsspannungsabhängigkeit der Signallaufzeit der NMOS-Grundschaltungen (N) kompensiert ist.

2. Integrierte CMOS/NMOS-Schaltung nach Anspruch 1 mit einem Ringoszillator, der p hintereinandergeschaltete CMOS-Inverter (ic) und q auf diese folgende, hintereinandergeschaltete NMOS-Depletion-Load-Inverter (id) enthält, von denen der Ausgang des letzten mit dem Eingang des ersten

CMOS-inverters verbunden ist, wobei p + q ungerade ist.

FIG. 1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACT OF JAPAN Band 9, Nr. 143 (E-322) (1866) 18. Juni 1985; & JP - A - 60 25323 (FUJITSU K.K.) 08-02-1985 --- | 1 | H 03 K 19/003 H 03 K 5/13 H 03 K 3/354 |
| A | EP-A-0 219 291 (NIPPON GAKKI SEIZO KABUSHIKI KAISHA) * Figuren 2,3; Spalte 1, Zeilen 9-24 * --- | | |
| A | IEEE JOURNAL OF SOLID-STATE CIRCUITS Band SC-13, Nr. 5, Oktober 1978, Seiten 542-548; R.W. KNEPPER: "Dynamic depletion mode: an E/D MOSFET circuit method for improved performance" * Abschnitt IV A; Figur 10 b * --- | | |
| A | IEEE TRANSACTIONS ON ELECTRON DEVICES Band ED-28, Nr. 7, Juli 1981, Seiten 886-888; D.C. MAYER et al.: "Analysis of the switching speed of a submicrometer-gate CMOS/SOS inverter" * Figuren 1,2 * ----- | | RECHERCHIERTE SACHGEBIETE (Int. Cl.4) H 01 L 27/08 H 03 H 11/26 H 03 K 3/01 H 03 K 3/354 H 03 K 5/13 H 03 K 19/00 H 03 K 19/003 H 03 K 19/094 H 03 K 19/096 |

Der vorliegende Recherchenbericht wurde für alle Patentansprüche erstellt

| Recherchenort | Abschlußdatum der Recherche | Prüfer |
|---|---|---|
| BERLIN | 27-11-1988 | ARENDT M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument